# EUROPEAN PATENT SPECIFICATION

(11) **EP 1 766 477 B1**
(45) Date of publication and mention of the grant of the patent: **14.05.2008**
(21) Application number: 05752681.6
(22) Date of filing: 08.06.2005
(51) Int. Cl.: G03F 7/16, B41N 1/12, B41N 3/00

(54) **METHOD AND APPARATUS FOR THE DRYING OF THE PRINTING PLATES FOR FLEXOGRAPHY**
VERFAHREN UND VORRICHTUNG ZUM TROCKNEN DER DRUCKPLATTEN IN DER FLEXOGRAPHIE
PROCÉDÉ ET APPAREIL POUR LE SÉCHAGE DES PLAQUES D'IMPRESSION FLEXOGRAPHIQUES

(30) Priority: 10.06.2004 EP 04102647
(43) Date of publication of application: 28.03.2007
(73) Proprietor: Degraf S.P.A., 20084 Lacchiarella (IT)
(72) Inventor: DE CARIA, Riccardo, I-20080 Basiglio (IT)
(74) Representative: Borsano, Corrado
(86) International application number: PCT/EP2005/052650
(87) International publication number: WO 2005/121898

(56) References cited:
- WO-A-20/04030923
- US-A- 4 478 931
- US-A1- 2004 081 908

## Description

### Field of the invention

The present invention relates to a method and apparatus for the drying of the printing plates for flexography.

### Prior art

As known, flexography is a printing technique using flexible printing plates preferably made of a photopolimeric material like rubber or plastic. The inked plates with a slightly raised image are rotated on a cylinder which transfers the image to the substrate. Flexography is a high-speed print process, can print on many types of absorbent and non-absorbent materials, and can print continuous patterns (such as for giftwrap and wallpaper).

Some typical applications for flexography are paper and plastic bags, milk cartons, disposable cups, and candy bar wrappers. Flexography printing may also be used for envelopes, labels, and newspapers. It is frequently used for printing on plastic, foil, acetate film, brown paper, and other materials used in packaging.

One of the steps for the preparation of printing plates for flexography is the plate drying, to allow the solvent, penetrated inside the plate in the previous phases for eliminating the non-etched parts of the plate, to evaporate.

The state of the art for the printing plate drying step, as described for example in US-4478931, or US-4806506, or US-5085976, is to create a flow of hot air, at a velocity of about 1-1.5 m/s, above the plates, in a plate chamber, to allow the solvent going out of the plate to evaporate due to the plate heating. The temperature of the air is controlled to not go beyond a threshold of 60° C, to avoid permanent deformation of the plates.

The total time needed for completing the drying step depends on the plate thickness, and is around one hour for every millimeter of plate thickness. As in the practice the normal plate thickness available on the market ranges from 1.14 to 7,00 mm, the total time needed for completing the drying step is 1 to 7 hours. Additional air drying overnight (sixteen hours or even more) is common. This long time is therefore a problem.

The long time is needed for the fact that, due to the low thermal conductivity of the material of the plate, the use of hot air for the plate heating renders the temperature of the plate surface higher than inside. Therefore also the tension (pressure) of the solvent is higher on the plate surface than inside, hindering the migration of the solvent from inside the plate to the outside.

On the other hand, the drying step must ensure a complete evaporation of the solvent before the exposure of the plate to UVC and UVA rays in the following step for preparing the printing plate, otherwise that exposure to UVC rays creates the effect of forming a sort of layer (film) on the surface of the plate, hindering a following evaporation of the solvent.

Another known technique for drying the printing plates for flexography is to irradiate the plates by infrared rays, typically using an infrared owen, as described for example in US-4478931, or US-4806506, or US 2004/0081908. This kind of technique creates similar (or even worse) problems as the hot air flow described above. In fact the infrared rays tend to remain on the surface of the plate and not penetrate the inside, with the effect of heating much more the surface than the inside of the plate. This creates difficulties in the control of the temperature on the surface of the plate.

### Summary of the invention

Therefore in view of the above mentioned problems, it is the main purpose of the present invention to provide a method and apparatus for the drying step of the printing plates for flexography, which reduces drastically the total time needed, basically by heating the inside of the plate at a temperature equal to or higher than that of the surface, to allow the solvent to migrate more rapidly, and also rendering the solvent recovering much easier and cheaper.

The basic idea of the present invention is to heat the printing plates by irradiation of visible light, preferably in the range of 400-650 nm wavelength.

The visible light penetrates the plate which is transparent at these wavelengths, and is reflected by the base of the plate. The light is refracted inside the plate, heating it inside as well as on the surface. The solvent particles change to the gaseous state and migrate toward the surface rapidly. The migration velocity is such that the plate thickness does not affect the total time needed for drying. Typically a total time of 15/30 min is sufficient for taking all the solvent away, independently from the plate thickness, and also keeping into account that the temperature is controlled not to go beyond the threshold of 60°C, thus ensuring the stability of the material making up the plate. For example in the use in the packaging sector (printing on corrugated boards) the typical plate thickness is 3 to 7 mm, therefore the saving of time and energy is extremely high.

A particular subject of the present invention is a method for drying printing plates for flexography, so as to let a solvent present inside the plates to evaporate, characterized in that it comprises the step of heating the printing plates by irradiation of visible light wavelengths.

Another subject of the present invention is an apparatus for drying printing plates for flexography, so as to let a solvent present inside the plates to evaporate, characterized in that it comprises:
- a base element for carrying the printing plates;
- a lighting system above the printing plates for heating the printing plates by irradiation of visible light wavelengths.

The apparatus also comprises means for eliminating an unwanted parasitic emission of infrared rays.

These and further objects are achieved by means of a method and apparatus for the drying step of the printing plates for flexography, as described in the attached claims, which are considered an integral part of the present description.

### Brief description of the drawings

The invention will become fully clear from the following detailed description, given by way of a mere exemplifying and non limiting example, to be read with reference to the attached drawing figures, wherein:
- Fig. 1 shows a schematic side sectional view of a first embodiment of an apparatus for the drying of the printing plates in accordance with the invention;
- Fig. 2 shows another side view of the first embodiment, perpendicular to that of fig. 1;
- Fig. 3 shows a top view of the first embodiment, more specifically showing the lighting system according to the invention;
- Fig. 4 shows the air flow directions in the printing plate chamber of the first embodiment;
- Figures 5 and 6 show two schematic side sectional views, perpendicular to each other, of a first variant of a second embodiment of an apparatus for the drying of the printing plates in accordance with the invention;
- Figures 7 and 8 show two schematic side sectional views, perpendicular to each other, of a second variant of the second embodiment;
- Fig 9 shows graphically the trend of the power with the wavelength of the incandescent lamps of the second embodiment;
- Fig. 10 shows graphically the trend, with the wavelength of the incandescent lamps, of the absoption per cent for different types of printing plates;
- Figures 11 and 12 show graphically, for a plate sample of respectively 1,74 mm and 7 mm thickness, the trend with the time T of the weight W of the sample in the solvent absorption step (left side) and in the drying step (right side).

The same reference numerals and letters in the figures designate the same elements.

### Description of the preferred embodiment

The method for drying printing plates for flexography subject of the invention comprises the step of heating the printing plates by irradiation of visible light wavelengths.

Preferably the irradiation of visible light wavelengths is in the range of 400-650 nm wavelengths. In fact, as it will be described below, with reference to the tests performed on some samples of printing plates, the range of wavelengths in which the effect of migration of the solvent to the outside of the plate is more efficient and quick is just that one, while above about 650 nm, the migration effect decreases, and the corresponding irradiation energy becomes more and more useless as the wavelength increases, and should be eliminated.

Preferably the method also comprises the step of letting a flow of air pass over the plates, for taking the solvent vapour emanating from the plates away.

Preferably the method also provides for bringing the flow of air passing over the plates to an air purification system to recover the solvent, so as to reduce pollution as much as possible.

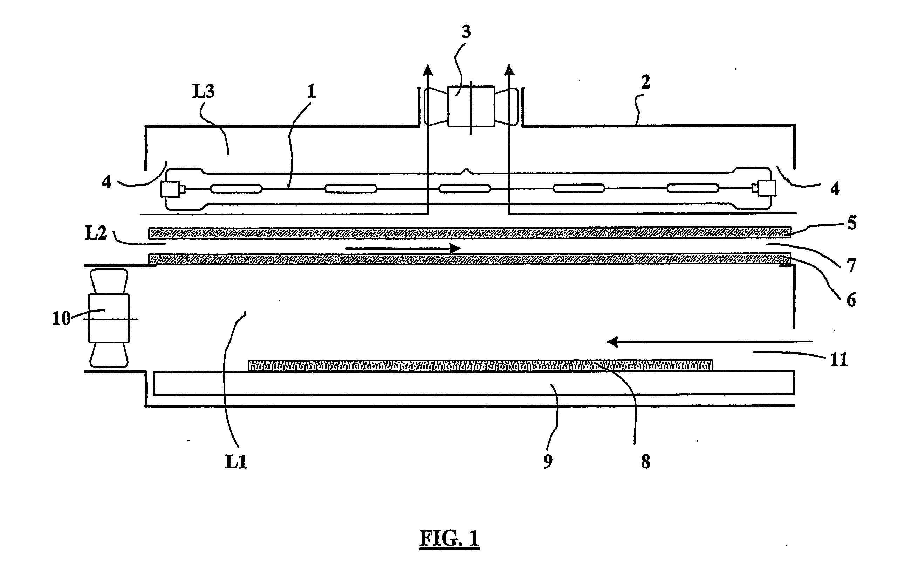

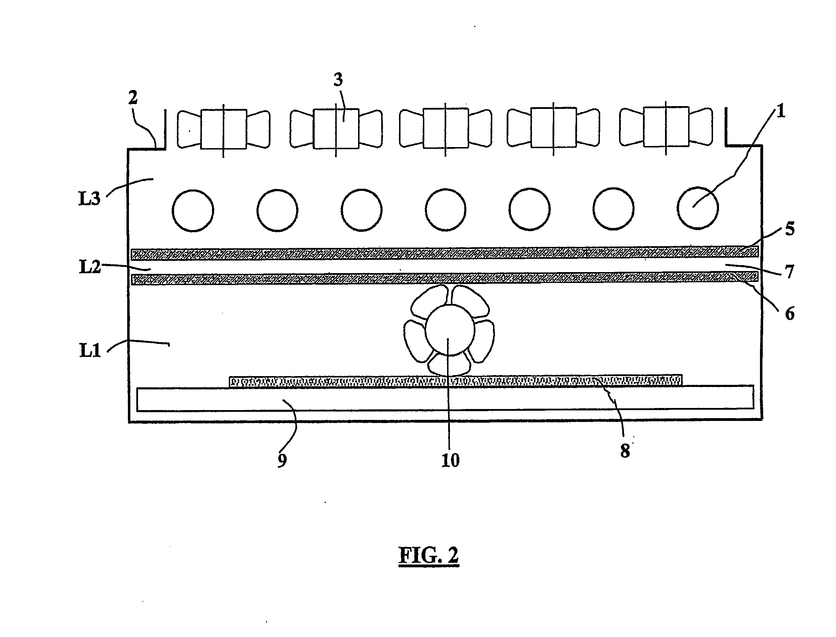

As shown in figures 1 and 2, a first embodiment of an apparatus for drying the printing plates comprises the following elements, from the bottom of the figures: an extractable box comprising a base element 9 for carrying the printing plates 8; above the printing plates, preferably two interspaced sheets of tempered glass, 5 and 6; above the glass sheets, a lighting system 1, described in details below, inside a tank for air depression 2.

Suitable fan systems 3 and 10 are also provided for the air circulation, as described below.

The apparatus is divided in three layers, L1, L2 and L3.

The lower layer L1 forms a chamber for hosting the printing plates to be dried. An hollow space above the plates 8 is created possibly having the glass sheet 6 as a cap: an air flow is created by air inlet 11 and air outlet where a fan system 10 is located. The arrow shows the air flow direction.

As explained above, a light flow of low velocity room temperature air is created, preferably in the range of 0.1 to 0.5 m/s, for taking the solvent vapour emanating from the plates away. The air is someway heated by the hot temperature developed over the plates, around 60°C. Due to the low velocity of the air, the temperature gradient inside the plate chamber is also low, and this is an advantage for the better uniformity of temperature inside the chamber.

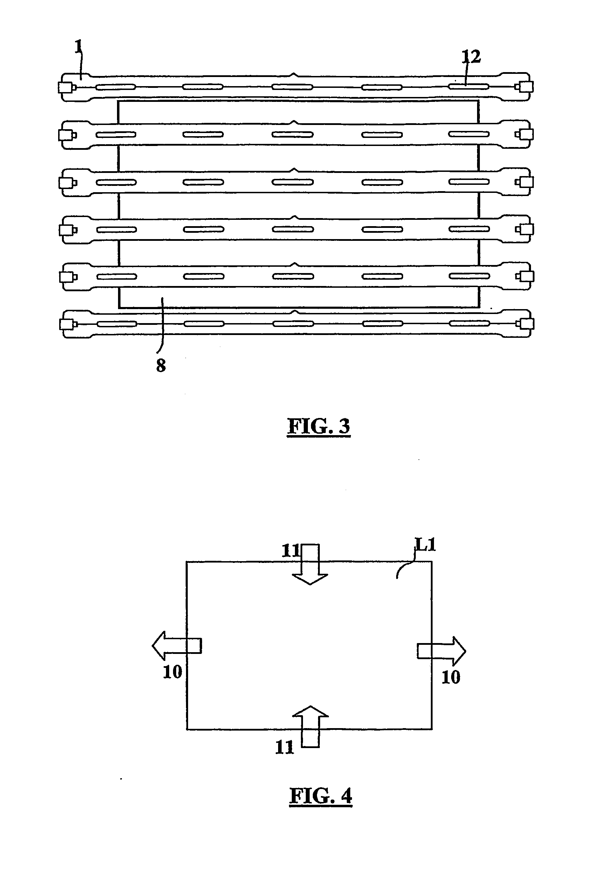

A preferred scheme of air flow in the chamber L1 is as shown in fig. 4, with two air inlets 11 at opposite sides with respect to two air outlets 10. This allows a further reduction of temperature gradient inside the chamber.

An air purification system, not shown in the figures, is connected to the air outlets 10, and can be dimensioned according to the average air flow in the chamber L1. With a drying time of 20 min, a total air flow of 10 m³ is enough.

The air purification system can be of any known type, preferably of the refrigeratory type. This because the solvent includes a volatile component (aliphatic alchool) that can also be completely recovered through a system like this.

The whole of the solvent can be recovered this way, by air condensation. As an example, for a plate of 2 m², a quantity of about 50 cc of solvent is recovered for each millimeter of plate thickness.

The upper layer L3 forms a chamber for hosting the lighting system 1. The glass sheet 5 is the floor of the chamber, while the cap is a tank 2 for air depression.

The lighting system 1 must be suitable to the purpose of creating a uniform irradiation of visible light wavelengths towards the plates located in the lower layer L1, as all the points of the plate surface must receive the same quantity of light rays, namely the same energy and temperature. The difference in the level of irradiation in the different points of the plate surface 8 has to remain within a range of 6-7 %.

An embodiment of the lighting system 1 is shown in fig. 3. It comprises a number of parallel normal quartz lamps 1, having a particular geometry depending on the distance from the plates, for irradiation of of visible light wavelengths, with a preferred emission in the range of red wavelengths (400 - 780 nm), so as to generate heating. An unavoidable parasitic emission in the range of infrared wavelengths is also present, to be eliminated as described below.

Each lamp irradiates with an intensity decreasing more or less linearly with the angle of irradiation; putting the lamps at a relative distance equal to that with respect to the plates, in the different points of the plates the total irradiation is given by the sum of the contributions of two contiguous lamps with a mutual compensation, so giving a uniform level of irradiation in the different points.

Each lamp has a series of lighting sectors 12 with an individual length equal to the distance between them and equal to the distance between the different lamps, so as to form a complete two-dimensional grid of lighting sectors.

In a non limiting example this common distance is 40 mm.

To ensure a uniform lighting level even at the boundaries of the surface to be lighted, the dimensions of the grid of lighting sectors of the lamps exceeds that of the plate surface 8 to be lighted by a value equal to the common distance. In the specific example if the maximum dimension of the plates is 1320 x 2000 mm, the dimensions of the grid of lighting sectors will be 1400 x 2080 mm.

The power supply voltage of the quartz lamps depends on the total length of the lighting sectors of the lamp. Therefore the lamps are so designed as to be supplied by normal existing power supply voltage, for example a three-phase 400 V. In some installations with a considerable total length to be lighted, it is possible to put two or more lamps connected in series, so as each lamp can be still powered by available voltage.

By means of the tank 2 for air depression, a cooling system for the lamps is obtained. A clean room-temperature air, which does not need any purification action, enters the chamber L3 from air inlets 4, makes a cooling action passing through the lamps, and is taken away from the air outlet 3, by a suitable fan system on the cap 2.

The intermediate layer L2 in between the two glass sheets 5 and 6 is created to eliminate the effects of the parasitic infrared emission by the lighting system 1, and transparent to the wanted visible light wavelengths, which pass through and reach the lower layer L1. The sheet 5 nearer to the lamps reflects a part of infrared emission back towards the lamps; a remaining part of infrared wavelengths is refracted towards the other sheet 6 and reflected back. This remaining part reflects and bounces in the interspace 7 between the two sheets: the relating energy is dissipated by generating heating which is taken away by a suitable air flow. This is a clean room-temperature air which does not need any purification action.

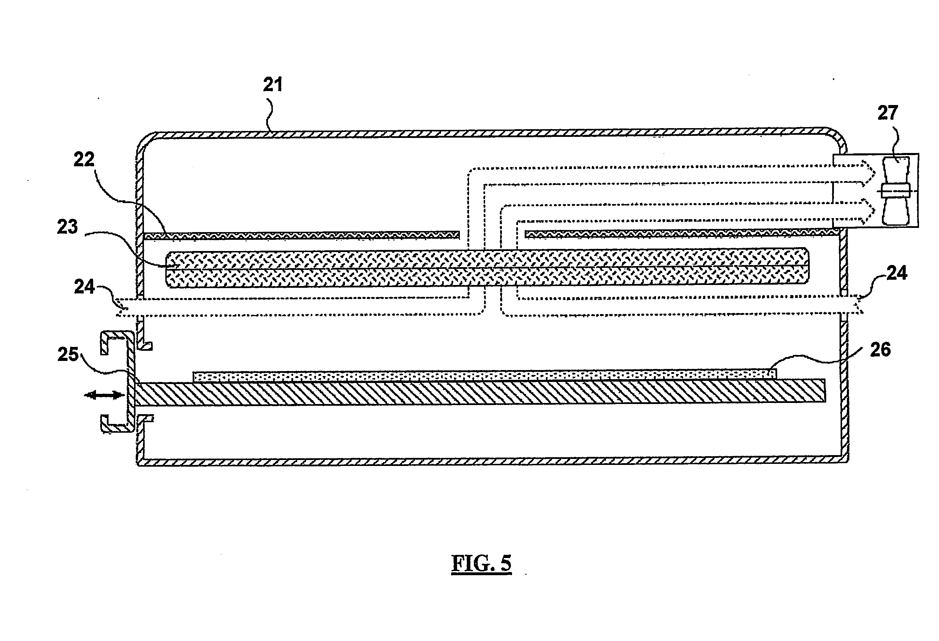

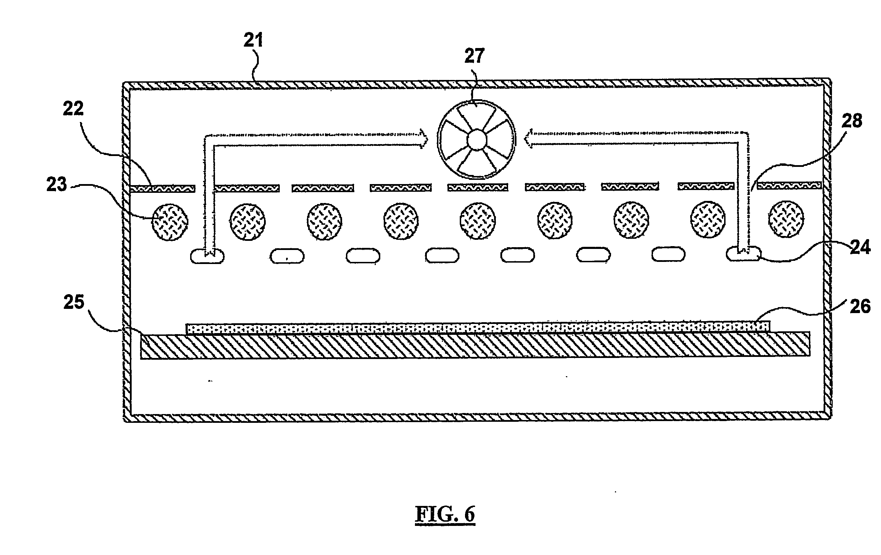

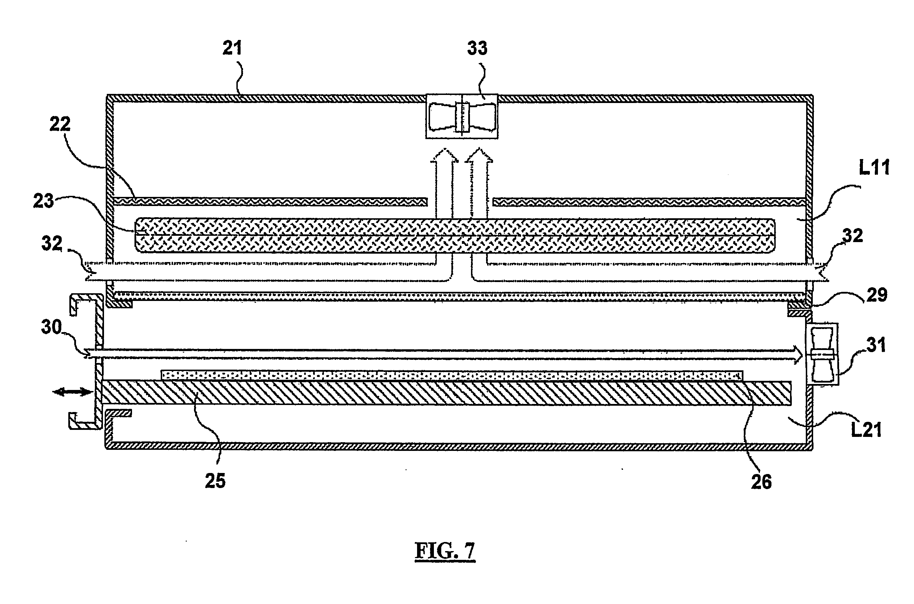

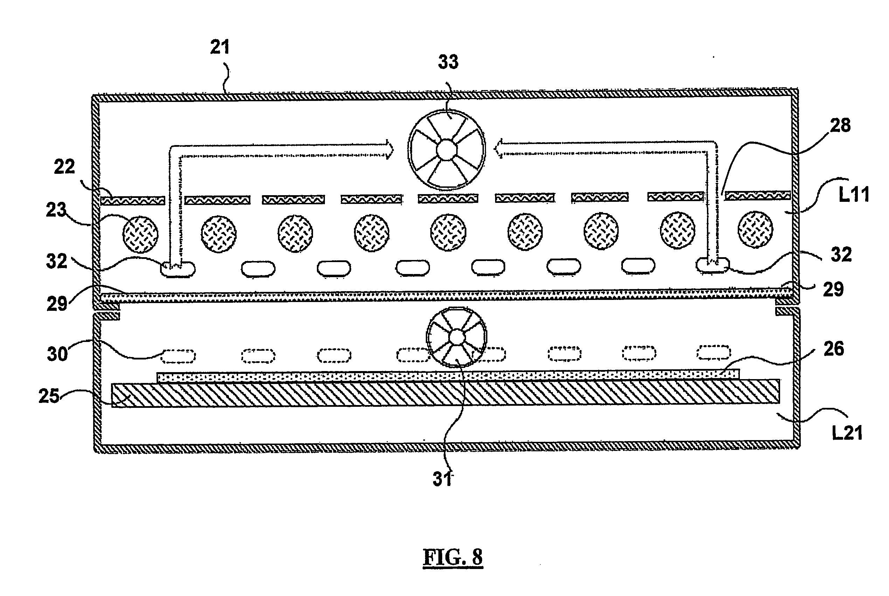

A second embodiment of the apparatus for drying the printing plates is shown in figures 5 and 6 in a first variant, and in figures 7 and 8 in a second variant.

It provides for a lighting system having normal incandescent lamps 23, preferably of linear filament shape disposed parallel over a printing plate 26 to be dried, so as to generate heating. An unavoidable parasitic emission in the range of infrared wavelengths is also present, to be possibly eliminated as described below. The plate is put on a base element 25 preferably in an extractable box.

Preferably a reflector 22 is present above the lamps 23, so as to concentrate the most of the irradiation on the direction of the plate 26, and to ensure a uniform lighting level in all the points of the surface to be lighted. The reflector 22 can be made of a surface of smoothed aluminium, to get the maximum reflection efficiency.

In the first variant of figures 5 and 6, the apparatus comprises a body 21, enclosing all the elements in one layer only. A number of openings 24 is obtained in the walls of the body, as well as a number of openings or slots 28 is present in the reflector 22. A fan system 27 is present above the reflector 22, so as to create a flow of air (dotted arrows) through the openings 24 and 28. The air passes over the plate and takes the solvent vapour emanating from the heated plate away, and it takes also the heat from the plate away, keeping the plate at a temperature below 60°C, as needed.

The flow of air needed is a strong one, with a typical value of about 350 m³ per hour. This way the negative effect of the parasitic emission of infrared rays from the lamps is eliminated, as the flow of air cools mainly the surface of the plate, just where the most of the heating caused by the infrared rays is generated.

This first variant is simple and cheap to reach the main purpose of the present invention. On the other hand, due to the huge flow of air needed, in practice it is hard to realize a recovery system for the solvent vapour emanating from the plate.

In the second variant of figures 7 and 8 the apparatus comprises two layers L11 and L21, divided by one tempered glass sheet 29. In the upper layer L11 above the glass sheet 29 there are the lamps 23 and the reflector 22. In the lower layer L21 there are the printing plate 26 and the base element 25. A number of openings 32 is obtained in the walls of the upper part of the body, as well as a number of openings or slots 28 in the reflector 22. A fan system 33 is present above the reflector 22, so as to create a first flow of air (dotted arrows) through the openings 32 and 28. This first flow of air cools the lamps 23. The parasitic emission of infrared rays from the lamps is eliminated by reflection or absorption of the tempered glass sheet 29 in which a suitable IR filter is present. The relating heating effect is taken away by the first flow of air.

A number of openings 30 is obtained in the walls of the lower part of the body in the lower layer L21, and a fan system 31 is present aside and just above the plate, so as to create a second flow of air through the openings 30, passing over the plate and to the purpose of both cooling the plate, keeping it a a temperature below 60°C, and taking the solvent vapour emanating from the heated plate away. The second flow of air is a light flow of low velocity room temperature air, making it possible to implement a recovery system for the solvent vapour emanating from the plate, for example of the kind described above.

Typical values for the two flows of air are about 350 m³ per hour for the first flow, and 20 m³ per hour for the second flow.

The experimental tests described in the following have shown the effectiveness of the method and apparatus subject of the invention.

The tests have been performed using printing plates for flexography having different thickness, for example 1,74 mm and 7 mm. For each thickness a squared sample has been taken of 10 cm x 10 cm wide.

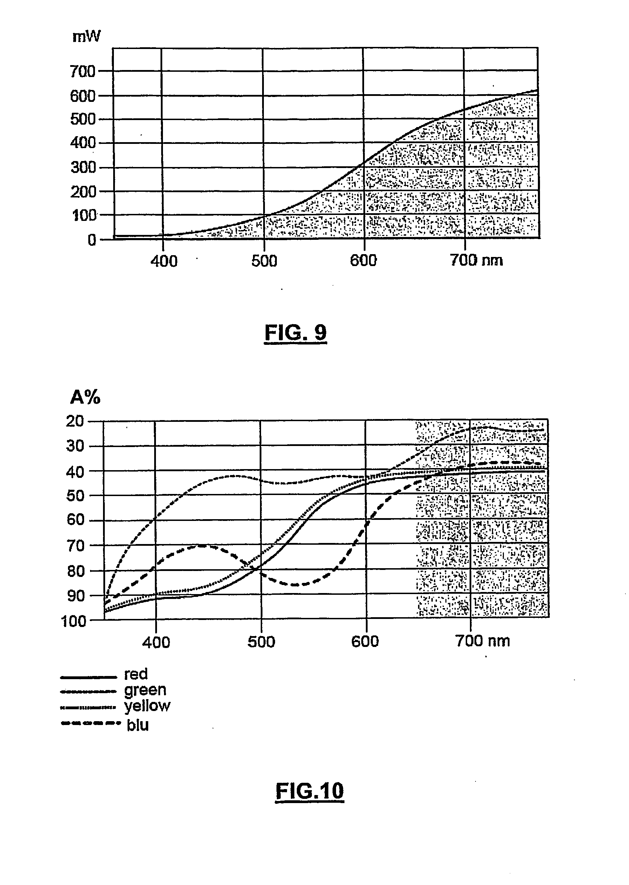

First, the sample has been exposed to UVA rays for the polymerization step. Then it has been weighted with a very precise balance and thereafter processed with solvent for the normal time needed depending on the thickness and type of the plate. Then it has been weighted again, and dried with the incandescent lamps of the second embodiment, having a spectral emission as shown in fig. 9. The sample has been weighted every 5^{th} minute, till when it has reached the starting weight again (that it had before the processing with the solvent)

Fig 9 shows the trend of the power (in mW) with the wavelength (in nm) of the incandescent lamps. Fig. 10 shows the trend, with the wavelength (in nm) of the incandescent lamps, of the absorption per cent A% for different types of printing plates having different color (the type of dotted or full lines identifies the color of the plate, respectively red, green, yellow, blu). The higher the absorption per cent for the given wavelength in the plate, the better the effect of migration of the solvent to the outside of the plate. It is evident that the best result for the absorption process is obtained in the range of 400-650 nm.

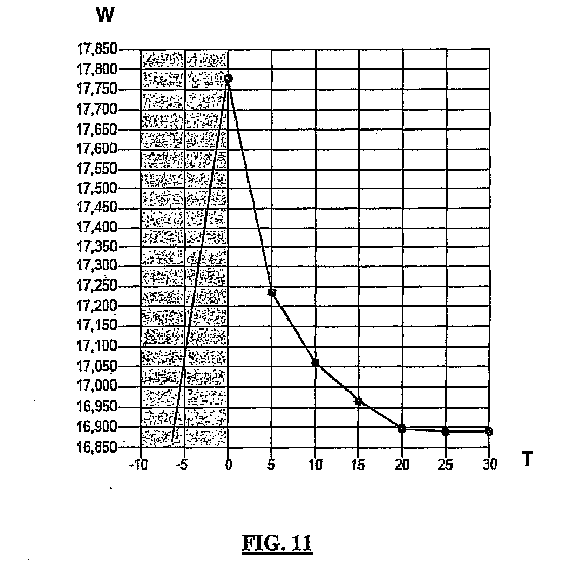

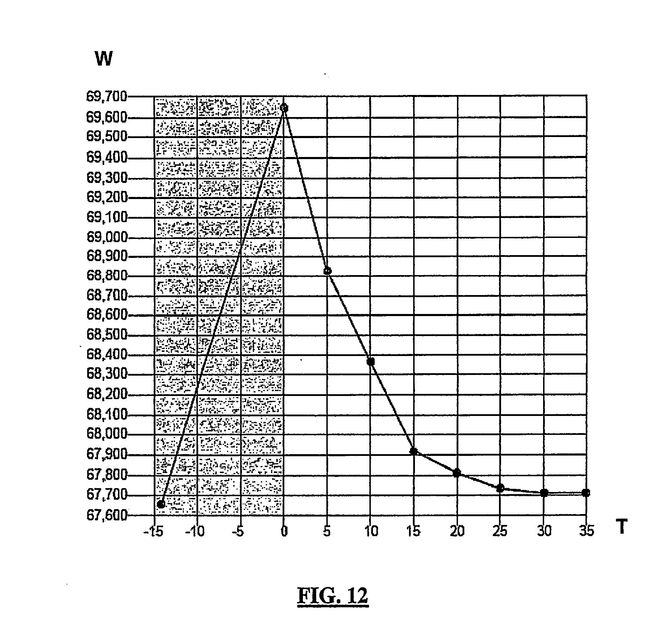

Figures 11 and 12 show, for a plate sample of respectively 1,74 mm and 7 mm thickness, the trend with the time T of the weight W of the sample in the solvent absorption step (left side) and in the drying step (right side).

In the first case (fig. 11) the weight of the solvent absorbed by the plate is 1 g, while in the second case (fig. 12) is 2 g.

In both cases after 30 or 35 minutes drying, the sample plate has reached the original weight again, that's all the solvent has been taken away.

This is the proof of the effectiveness of the method of the present invention. The time necessary for the drying step does not depend on the plate thickness and is very short as compared with the drying time needed with the methods known in the art.

The lighting system of the second embodiment of the apparatus for drying the printing plates shows a much lower level of emission of parasitic infrared rays than the first one, so the presence of the tempered glass sheet may not be necessary in the most of the practical applications.

To control the temperature of the printing plate so as not to go beyond the threshold of 60°C, some normal temperature probes not shown in the figures are put near to the plates on the base element 9 or 25, so as to regulate the switching (duty-cycle) of the lamps by a suitable state-of-the-art circuitry.

Further implementation details will not be described, as the man skilled in the art is able to carry out the invention starting from the teaching of the above description.

## Claims

1. Method for drying printing plates for flexography, so as to let a solvent present inside the plates to evaporate, **characterized in that** it comprises the step of heating the printing plates by irradiation of visible light wavelengths.

2. Method according to claim 1, **characterized in that** said irradiation of visible light wavelengths is in the range of 400-650 nm wavelengths.

3. Method according to claim 1, **characterized in that** it also comprises the step of letting a flow of air pass over the plates, for taking the solvent vapour emanating from the plates away, and for cooling the plates.

4. Method according to claim 3, **characterized in that** the flow of air is at low velocity, preferably in the range of 0.1 to 0.3 m/s, and at room-temperature.

5. Method according to claim 3, **characterized in that** said air passing over the plates is brought to an air purification system to recover the solvent.

6. Method according to claim 1, **characterized in that** said irradiation of visible light wavelengths is made uniform over the plates.

7. Method according to claim 1, **characterized in that** said irradiation of visible light wavelengths is made by a number of lamps put over the printing plates.

8. Method according to claim 7, **characterized in that** said number of lamps are quartz lamps or incandescent lamps.

9. Method according to claim 7, **characterized in that** said number of lamps is put in a separated layer from the plate layer, by an intermediate layer transparent to the visible light wavelengths.

10. Method according to claim 7, **characterized in that** said number of lamps are cooled by a clean room-temperature air flow.

11. Method according to claim 9, **characterized in that** said intermediate layer is able to eliminate a parasitic emission of infrared wavelengths by said number of lamps.

12. Apparatus for drying printing plates for flexography, so as to let a solvent present inside the plates to evaporate, **characterized in that** it comprises:
- a base element (9, 25) for carrying the printing plates (8, 26);
- a lighting system (1, 23) above the printing plates for heating the printing plates by irradiation of visible light wavelengths.

13. Apparatus according to claim 12, **characterized in that** said irradiation of visible light wavelengths is in the range of 400-650 nm wavelengths.

14. Apparatus according to claim 12, **characterized in that** said lighting system (1, 23) creates a uniform irradiation of visible light wavelengths over the plates, even at the boundaries of the base element.

15. Apparatus according to claim 12, **characterized in that** said lighting system (1, 23) comprises a number of quartz lamps (1).

16. Apparatus according to claim 15, **characterized in that** said number of quartz lamps (1) are parallely disposed, at a relative distance equal to that with respect to the plates.

17. Apparatus according to claim 16, **characterized in that** each of said quartz lamps comprises a series of lighting sectors (12) with an individual length equal to the distance between them and equal to the distance between the different lamps, so as to form a complete two-dimensional grid of lighting sectors.

18. Apparatus according to claim 17, **characterized in that** the dimensions of the grid of lighting sectors exceeds that of the plate surface (8) by a value equal to said distance.

19. Apparatus according to claim 15, **characterized in that** it further comprises a first intermediate layer (L2) between the base element (9) and the quartz lamps (1), to eliminate the effects of the parasitic infrared emission by said quartz lamps (1), and transparent to the visible light wavelengths.

20. Apparatus according to claim 19, **characterized in that** it further comprises first means (10, 11) for creating a flow of air over the plates, for taking the solvent vapour emanating from the plates away, and for cooling the plates.

21. Apparatus according to claim 20, **characterized in that** said flow of air is at low velocity room temperature, preferably in the range of 0.1 to 0.3 m/s.

22. Apparatus according to claim 21, **characterized in that** it further comprises an air purification system receiving said flow of low velocity room temperature air, for recovering said solvent.

23. Apparatus according to claim 22, **characterized in that** said air purification system is of the refrigeratory type.

24. Apparatus according to claim 19, **characterized in that** said first intermediate layer (L2) comprises two interspaced sheets of tempered glass (5, 6).

25. Apparatus according to claim 24, **characterized in that** said first intermediate layer (L2) comprises a first cooling system creating an air flow in said interspace.

26. Apparatus according to claim 15, **characterized in that** it comprises a second cooling system (3, 4) for said quartz lamps (1).

27. Apparatus according to claim 12, **characterized in that** said lighting system (1, 23) comprises a number of incandescent lamps (23).

28. Apparatus according to claim 27, **characterized in that** said incandescent lamps (23) are of the linear filament shape disposed parallel over said printing plates.

29. Apparatus according to claim 28, **characterized in that** it further comprises a reflector (22) above said number of incandescent lamps.

30. Apparatus according to claim 29, **characterized in that** said reflector (22) is made of a surface of smoothed aluminium.

31. Apparatus according to claim 27, **characterized in that** it further comprises a second intermediate layer (29) between the base element (25) and the incandescent lamps (23), to eliminate the effects of the parasitic infrared emission by said quartz lamps (1), and transparent to the visible light wavelengths.

32. Apparatus according to claim 31, **characterized in that** it further comprises second means (30, 31) for creating a flow of air over the plates, for taking the solvent vapour emanating from the plates away, and for cooling the plates.

33. Apparatus according to claim 32, **characterized in that** said flow of air is at low velocity room temperature, preferably in the range of 0.1 to 0.3 m/s.

34. Apparatus according to claim 33, **characterized in that** it further comprises an air purification system receiving said flow of low velocity room temperature air, for recovering said solvent.

35. Apparatus according to claim 31, **characterized in that** said second intermediate layer (29) comprises a sheet of tempered glass.

36. Apparatus according to claim 35, **characterized in that** it comprises a third cooling system (32, 33) for said incandescent lamps (23).

37. Apparatus according to claim 27, **characterized in that** it further comprises third means (24, 27) for creating a flow of air over the plates, for taking the solvent vapour emanating from the plates away, and for cooling the plates.

38. Apparatus according to claim 37, **characterized in that** said third means (24, 27) for creating a flow of air over the plates are able to eliminate the effects of the parasitic infrared emission by said incandescent lamps (23).

39. Apparatus according to claim 27, **characterized in that** said incandescent lamps (23) are cooled by said third means (24, 27) for creating a flow of air over the plates.

40. Apparatus according to claim 12, **characterized in that** it further comprises means to control the temperature of the printing plates to stay below 60°C.

## Patentansprüche

1. Verfahren zum Trocknen von Druckplatten für einen Flexodruck, um ein Lösungsmittel, das sich in den Platten befindet, verdampfen zu lassen,
**dadurch gekennzeichnet, dass**
es den Schritt umfasst, dass die Druckplatten durch Strahlung von Licht sichtbarer Wellenlängen erwärmt werden.

2. Verfahren nach Anspruch 1,
**dadurch gekennzeichnet, dass**
die Strahlung von Licht sichtbarer Wellenlängen in dem Wellenlängenbereich von 400 - 650 nm liegt.

3. Verfahren nach Anspruch 1,
**dadurch gekennzeichnet, dass**
es auch den Schritt umfasst, dass man eine Strömung von Luft über die Platten gelangen lässt, um den Lösungsmitteldampf, der von den Platten ausströmt, wegzuführen und um die Platten zu kühlen.

4. Verfahren nach Anspruch 3,
**dadurch gekennzeichnet, dass**
die Strömung von Luft eine niedrige Geschwindigkeit, vorzugsweise in dem Bereich von 0,1 bis 0,3 m/s, und Raumtemperatur hat.

5. Verfahren nach Anspruch 3,
**dadurch gekennzeichnet, dass**
die Luft, die über die Platten gelangt, in ein Luftreinigungssystem gebracht wird, um das Lösungsmittel zurück zu gewinnen.

6. Verfahren nach Anspruch 1,
**dadurch gekennzeichnet, dass**
die Strahlung von Licht sichtbarer Wellenlängen über den Platten einheitlich vorgenommen wird.

7. Verfahren nach Anspruch 1,
**dadurch gekennzeichnet, dass**
die Strahlung von Licht sichtbarer Wellenlängen durch eine Anzahl von Lampen vorgenommen wird, die über den Druckplatten angeordnet sind.

8. Verfahren nach Anspruch 7,
**dadurch gekennzeichnet, dass**
die Anzahl von Lampen Quarzlampen oder Glühlampen umfasst.

9. Verfahren nach Anspruch 7,
**dadurch gekennzeichnet, dass**
die Anzahl von Lampen mittels einer Zwischenschicht, die für das Licht sichtbarer Wellenlängen durchlässig ist, in einer von der Plattenschicht separaten Schicht angeordnet ist.

10. Verfahren nach Anspruch 7,
**dadurch gekennzeichnet, dass**
die Anzahl von Lampen durch eine Strömung von sauberer Luft mit Raumtemperatur gekühlt wird.

11. Verfahren nach Anspruch 9,
**dadurch gekennzeichnet, dass**
die Zwischenschicht eine parasitäre Emission von Infrarotwellenlängen durch die Anzahl von Lampen beseitigen kann.

12. Vorrichtung zum Trocknen von Druckplatten für einen Flexodruck, um ein Lösungsmittel, das sich in den Platten befindet, verdampfen zu lassen,
**gekennzeichnet durch**:
- ein Basiselement (9, 25) zum Tragen der Druckplatten (8, 26);
- ein Beleuchtungssystem (1, 23) über den Druckplatten zum Erwärmen der Druckplatten **durch** Strahlung von Licht sichtbarer Wellenlängen.

13. Vorrichtung nach Anspruch 12,
**dadurch gekennzeichnet, dass**
die Strahlung von Licht sichtbarer Wellenlängen in dem Wellenlängenbereich von 400 - 650 nm liegt.

14. Vorrichtung nach Anspruch 12,
**dadurch gekennzeichnet, dass**
das Beleuchtungssystem (1, 23) sogar an den Grenzen des Basiselements eine einheitliche Strahlung von Licht sichtbarer Wellenlängen über den Platten erzeugt.

15. Vorrichtung nach Anspruch 12,
**dadurch gekennzeichnet, dass**
das Beleuchtungssystem (1, 23) eine Anzahl von Quarzlampen (1) umfasst.

16. Vorrichtung nach Anspruch 15,
**dadurch gekennzeichnet, dass**
die Anzahl von Quarzlampen (1) mit einer relativen Distanz, die gleich der in Bezug auf die Platten ist, parallel angeordnet ist.

17. Vorrichtung nach Anspruch 16,
**dadurch gekennzeichnet, dass**
jede der Quarzlampen eine Reihe von Beleuchtungssektoren (12) mit einer individuellen Länge umfasst, die gleich der Distanz zwischen diesen und gleich der Distanz zwischen den verschiedenen Lampen ist, um ein vollständiges zweidimensionales Gitter von Beleuchtungssektoren zu bilden.

18. Vorrichtung nach Anspruch 17,
**dadurch gekennzeichnet, dass**
die Abmessungen des Gitters von Beleuchtungssektoren die der Plattenfläche (8) um einen Wert übersteigen, der gleich der Distanz ist.

19. Vorrichtung nach Anspruch 15,
**dadurch gekennzeichnet, dass**
sie ferner eine erste Zwischenschicht (L2) zwischen dem Basiselement (9) und den Quarzlampen (1) zum Beseitigen der Auswirkungen der parasitären Infrarotemission durch die Quarzlampen (1) umfasst, die für das Licht sichtbarer Wellenlängen durchlässig ist.

20. Vorrichtung nach Anspruch 19,
**dadurch gekennzeichnet, dass**
sie ferner ein erstes Mittel (10, 11) zum Erzeugen einer Strömung von Luft über die Platten umfasst, um den Lösungsmitteldampf, der von den Platten ausströmt, wegzuführen und um die Platten zu kühlen.

21. Vorrichtung nach Anspruch 20,
**dadurch gekennzeichnet, dass**
die Strömung von Luft eine niedrige Geschwindigkeit, vorzugsweise in dem Bereich von 0,1 bis 0,3 m/s, und Raumtemperatur hat.

22. Vorrichtung nach Anspruch 21,
**dadurch gekennzeichnet, dass**
sie ferner ein Luftreinigungssystem umfasst, das die Strömung von Luft mit niedriger Geschwindigkeit und Raumtemperatur aufnimmt, um das Lösungsmittel zurück zu gewinnen.

23. Vorrichtung nach Anspruch 22,
**dadurch gekennzeichnet, dass**
das Luftreinigungssystem vom Kühltyp ist.

24. Vorrichtung nach Anspruch 19,
**dadurch gekennzeichnet, dass**
die erste Zwischenschicht (L2) zwei voneinander beabstandete Lagen von Hartglas (5, 6) umfasst.

25. Vorrichtung nach Anspruch 24,
**dadurch gekennzeichnet, dass**
die erste Zwischenschicht (L2) ein erstes Kühlsystem umfasst, das eine Luftströmung in dem Zwischenraum erzeugt.

26. Vorrichtung nach Anspruch 15,
**dadurch gekennzeichnet, dass**
sie ein zweites Kühlsystem (3, 4) für die Quarzlampen (1) umfasst.

27. Vorrichtung nach Anspruch 12,
**dadurch gekennzeichnet, dass**
das Beleuchtungssystem (1, 23) eine Anzahl von Glühlampen (23) umfasst.

28. Vorrichtung nach Anspruch 27,
**dadurch gekennzeichnet, dass**
die Glühlampen (23) die Form eines linearen Glühdrahts aufweisen und parallel über den Druckplatten angeordnet sind.

29. Vorrichtung nach Anspruch 28,
**dadurch gekennzeichnet, dass**
sie ferner einen Reflektor (22) über der Anzahl von Glühlampen umfasst.

30. Vorrichtung nach Anspruch 29,
**dadurch gekennzeichnet, dass**
der Reflektor (22) aus einer Fläche von geschliffenem Aluminium besteht.

31. Vorrichtung nach Anspruch 27,
**dadurch gekennzeichnet, dass**
sie ferner eine zweite Zwischenschicht (29) zwischen dem Basiselement (25) und den Glühlampen (23) zum Beseitigen der Auswirkungen der parasitären Infrarotemission durch die Quarzlampen (1) umfasst, die für das Licht sichtbarer Wellenlängen durchlässig ist.

32. Vorrichtung nach Anspruch 31,
**dadurch gekennzeichnet, dass**
sie ferner ein zweites Mittel (30, 31) zum Erzeugen einer Strömung von Luft über die Platten umfasst, um den Lösungsmitteldampf, der von den Platten ausströmt, wegzuführen und um die Platten zu kühlen.

33. Vorrichtung nach Anspruch 32,
**dadurch gekennzeichnet, dass**
die Strömung von Luft eine niedrige Geschwindigkeit, vorzugsweise in dem Bereich von 0,1 bis 0,3 m/s, und Raumtemperatur hat.

34. Vorrichtung nach Anspruch 33,
**dadurch gekennzeichnet, dass**
sie ferner ein Luftreinigungssystem umfasst, das die Strömung von Luft mit niedriger Geschwindigkeit und Raumtemperatur aufnimmt, um das Lösungsmittel zurück zu gewinnen.

35. Vorrichtung nach Anspruch 31,
**dadurch gekennzeichnet, dass**
die zweite Zwischenschicht (29) eine Lage aus Hartglas umfasst.

36. Vorrichtung nach Anspruch 35,
**dadurch gekennzeichnet, dass**
sie ein drittes Kühlsystem (32, 33) für die Glühlampen (23) umfasst.

37. Vorrichtung nach Anspruch 27,
**dadurch gekennzeichnet, dass**
sie ferner ein drittes Mittel (24, 27) zum Erzeugen einer Strömung von Luft über die Platten umfasst, um den Lösungsmitteldampf, der von den Platten ausströmt, wegzuführen und um die Platten zu kühlen.

38. Vorrichtung nach Anspruch 37,
**dadurch gekennzeichnet, dass**
das dritte Mittel (24, 27) zum Erzeugen einer Strömung von Luft über die Platten die Auswirkungen der parasitären Infrarotemission durch die Glühlampen (23) beseitigen kann.

39. Vorrichtung nach Anspruch 27,
**dadurch gekennzeichnet, dass**
die Glühlampen (23) durch das dritte Mittel (24, 27) gekühlt werden, um eine Strömung von Luft über die Platten zu erzeugen.

40. Vorrichtung nach Anspruch 12,
**dadurch gekennzeichnet, dass**
sie ferner ein Mittel zum Steuern der Temperatur der Druckplatten derart umfasst, dass sie unter 60°C bleibt.

## Revendications

1. Procédé pour le séchage de plaques d'impression flexographiques, de sorte à laisser s'évaporer un solvant présent à l'intérieur des plaques, **caractérisé en ce qu'**il comprend l'étape consistant à chauffer les plaques d'impression par irradiation de longueurs d'onde de lumière visible.

2. Procédé selon la revendication 1, **caractérisé en ce que** ladite irradiation de longueurs d'onde de lumière visible se situe dans la plage de longueurs d'onde allant de 400 à 650 nm.

3. Procédé selon la revendication 1, **caractérisé en ce qu'**il comprend également l'étape consistant à laisser un flux d'air passer sur les plaques pour tenir à distance la vapeur de solvant émanant des plaques et pour refroidir les plaques.

4. Procédé selon la revendication 3, **caractérisé en ce que** le flux d'air s'écoule à une faible vitesse, de préférence dans la plage allant de 0,1 à 0,3 m/s et est à température ambiante.

5. Procédé selon la revendication 3, **caractérisé en ce que** ledit air passant sur les plaques est amené dans un système de purification d'air pour récupérer le solvant.

6. Procédé selon la revendication 1, **caractérisé en ce que** ladite irradiation de longueurs d'onde de lumière visible est rendue uniforme sur les plaques.

7. Procédé selon la revendication 1, **caractérisé en ce que** ladite irradiation de longueurs d'onde de lumière visible est constituée d'un certain nombre de lampes placées sur les plaques d'impression.

8. Procédé selon la revendication 7, **caractérisé en ce que** ledit nombre de lampes est des lampes à quartz ou des lampes à incandescence.

9. Procédé selon la revendication 7, **caractérisé en ce que** ledit nombre de lampes est placé dans une couche séparée de la couche de plaque, par une couche intermédiaire transparente aux longueurs d'onde de lumière visible.

10. Procédé selon la revendication 7, **caractérisé en ce que** ledit nombre de lampes sont refroidies par un flux d'air pur et à température ambiante.

11. Procédé selon la revendication 9, **caractérisé en ce que** ladite couche intermédiaire peut éliminer une émission parasite de longueurs d'onde infrarouge par ledit nombre de lampes.

12. Appareil pour le séchage de plaques d'impression flexographiques, de sorte à laisser s'évaporer un solvant présent à l'intérieur des plaques, **caractérisé en ce qu'**il comprend :
- un élément de base (9, 25) pour porter les plaques d'impression (8, 26) ;
- un système d'éclairage (1, 23) au-dessus des plaques d'impression pour chauffer les plaques d'impression par irradiation de longueurs d'onde de lumière visible.

13. Appareil selon la revendication 12, **caractérisé en ce que** ladite irradiation de longueurs d'onde de lumière visible se situe dans la plage de longueurs d'onde allant de 400 à 650 nm.

14. Appareil selon la revendication 12, **caractérisé en ce que** ledit système d'éclairage (1, 23) crée une irradiation uniforme de longueurs d'onde de lumière visible sur les plaques, même au niveau des frontières de l'élément de base.

15. Appareil selon la revendication 12, **caractérisé en ce que** ledit système d'éclairage (1, 23) comprend un certain nombre de lampes à quartz (1).

16. Appareil selon la revendication 15, **caractérisé en ce que** ledit nombre de lampes à quartz (1) sont disposées en parallèle, à une distance relative égale à celle par rapport aux plaques.

17. Appareil selon la revendication 16, **caractérisé en ce que** chacune desdites lampes à quartz comprend une série de secteurs d'éclairage (12) avec une longueur individuelle égale à la distance entre eux et égale à la distance entre les différentes lampes, de sorte à former une grille bidimensionnelle complète de secteurs d'éclairage.

18. Appareil selon la revendication 17, **caractérisé en ce que** les dimensions de la grille de secteurs d'éclairage dépassent celles de la surface de plaque (8) d'une valeur égale à ladite distance.

19. Appareil selon la revendication 15, **caractérisé en ce qu'**il comprend en outre une première couche intermédiaire (L2) entre l'élément de base (9) et les lampes à quartz (1), pour éliminer les effets de l'émission infrarouge parasite par lesdites lampes à quartz (1), et transparente aux longueurs d'onde de lumière visible.

20. Appareil selon la revendication 19, **caractérisé en ce qu'**il comprend en outre un premier moyen (10, 11) pour créer un flux d'air sur les plaques, pour tenir à distance la vapeur de solvant émanant des plaques et pour refroidir les plaques.

21. Appareil selon la revendication 20, **caractérisé en ce que** ledit flux d'air s'écoule à une faible vitesse et est à température ambiante, de préférence dans la plage allant de 0,1 à 0,3 m/s.

22. Appareil selon la revendication 21, **caractérisé en ce qu'**il comprend en outre un système de purification d'air recevant ledit flux d'air de faible vitesse et à température ambiante, pour récupérer ledit solvant.

23. Appareil selon la revendication 22, **caractérisé en ce que** ledit système de purification d'air est du type réfrigérant.

24. Appareil selon la revendication 19, **caractérisé en ce que** ladite première couche intermédiaire (L2) comprend deux feuilles espacées en verre trempé (5, 6).

25. Appareil selon la revendication 24, **caractérisé en ce que** ladite première couche intermédiaire (L2) comprend un premier système de refroidissement créant un flux d'air dans ledit espacement.

26. Appareil selon la revendication 15, **caractérisé en ce qu'**il comprend un deuxième système de refroidissement (3, 4) pour lesdites lampes à quartz (1).

27. Appareil selon la revendication 12, **caractérisé en ce que** ledit système d'éclairage (1, 23) comprend un certain nombre de lampes à incandescence (23).

28. Appareil selon la revendication 27, **caractérisé en ce que** lesdites lampes à incandescence (23) ont la forme d'un filament linéaire disposé en parallèle sur lesdites plaques d'impression.

29. Appareil selon la revendication 28, **caractérisé en ce qu'**il comprend en outre un réflecteur (22) au-dessus dudit nombre de lampes à incandescence.

30. Appareil selon la revendication 29, **caractérisé en ce que** ledit réflecteur (22) est constitué d'une surface en aluminium lissé.

31. Appareil selon la revendication 27, **caractérisé en ce qu'**il comprend en outre une seconde couche intermédiaire (29) entre l'élément de base (25) et les lampes à incandescence (23), pour éliminer les effets de l'émission infrarouge parasite par lesdites lampes à quartz (1), et transparente aux longueurs d'onde de lumière visible.

32. Appareil selon la revendication 31, **caractérisé en ce qu'**il comprend en outre un deuxième moyen (30, 31) pour créer un flux d'air sur les plaques, pour tenir à distance la vapeur de solvant émanant des plaques et pour refroidir les plaques.

33. Appareil selon la revendication 32, **caractérisé en ce que** ledit flux d'air s'écoule à une faible vitesse et est à température ambiante, de préférence dans la plage allant de 0,1 à 0,3 m/s.

34. Appareil selon la revendication 33, **caractérisé en ce qu'**il comprend en outre un système de purification d'air recevant ledit flux d'air de faible vitesse et à température ambiante, pour récupérer ledit solvant.

35. Appareil selon la revendication 31, **caractérisé en ce que** ladite seconde couche intermédiaire (29) comprend une feuille en verre trempé.

36. Appareil selon la revendication 35, **caractérisé en ce qu'**il comprend un troisième système de refroidissement (32, 33) pour lesdites lampes à incandescence (23).

37. Appareil selon la revendication 27, **caractérisé en ce qu'**il comprend en outre un troisième moyen (24, 27) pour créer un flux d'air sur les plaques, pour tenir à distance la vapeur de solvant émanant des plaques et pour refroidir les plaques.

38. Appareil selon la revendication 37, **caractérisé en ce que** ledit troisième moyen (24, 27) pour créer un flux d'air sur les plaques peut éliminer les effets de l'émission infrarouge parasite par lesdites lampes à incandescence (23).

39. Appareil selon la revendication 27, **caractérisé en ce que** lesdites lampes à incandescence (23) sont refroidies par ledit troisième moyen (24, 27) pour créer un flux d'air sur les plaques.

40. Appareil selon la revendication 12, **caractérisé en ce qu'**il comprend en outre un moyen pour réguler la température des plaques d'impression de sorte à rester inférieure à 60 °C.
